(19) **Europäisches Patentamt**

**European Patent Office**

**Office européen des brevets**

(11) **EP 1 467 482 B1**

(12) **EUROPÄISCHE PATENTSCHRIFT**

(45) Veröffentlichungstag und Bekanntmachung des Hinweises auf die Patenterteilung:
**31.08.2005 Patentblatt 2005/35**

(51) Int Cl.⁷: **H03F 1/34**

(21) Anmeldenummer: **04005179.9**

(22) Anmeldetag: **04.03.2004**

(54) **Rückkopplungslinearisierte Sendereinrichtung**

Feedback linearised transmitter circuit

Circuit émetteur linéarisé rétroactivement

(84) Benannte Vertragsstaaten:
**DE FR GB**

(30) Priorität: **10.04.2003 DE 10316559**

(43) Veröffentlichungstag der Anmeldung:
**13.10.2004 Patentblatt 2004/42**

(73) Patentinhaber: **Rohde & Schwarz FTK GmbH**
**12557 Berlin (DE)**

(72) Erfinder: **Müssener, Karl-Martin**
**10555 Berlin (DE)**

(74) Vertreter: **Körfer, Thomas**
**Mitscherlich & Partner,**
**Patent- und Rechtsanwälte,**
**Sonnenstrasse 33**
**80331 München (DE)**

(56) Entgegenhaltungen:
EP-A- 0 951 143    WO-A-00/04634
WO-A-01/24467    US-A- 5 111 155
US-A- 5 903 611

• MUHONEN K ET AL: "Amplifier linearization for the local multipoint distribution system application" PERSONAL, INDOOR AND MOBILE RADIO COMMUNICATIONS, 1998. THE NINTH IEEE INTERNATIONAL SYMPOSIUM ON BOSTON, MA, USA 8-11 SEPT. 1998, NEW YORK, NY, USA,IEEE, US, 8. September 1998 (1998-09-08), Seiten 687-692, XP010314506 ISBN: 0-7803-4872-9

**Beschreibung**

Die Erfindung betrifft eine Sendereinrichtung, insbesondere für Hochfrequenz-Sendeanlagen, welche durch Rückkopplung linearisiert ist.

Sendereinrichtungen, welche ein Basisband-Signal aufbereiten und verstärkt abgeben sind allgemein bekannt. Um die Sendereinrichtung und insbesondere die Verstärkerstufen mit einem angemessen hohen Wirkungsgrad betreiben zu können, kann ein verbleibendes nichtlineares Verhalten, insbesondere der Verstärkerstufen, nicht vollständig vermieden werden.

Eine bei digitalen Sendereinrichtungen häufig verwendete Methode dieses verbleibende nichtlineare Verhalten zu neutralisieren bzw. zu kompensieren, ohne den Wirkungsgrad deutlich zu senken, ist die Rückkopplung (Cartesian feedback-Verfahren).

Aus der DE 199 46 669 A1 ist beispielsweise ein Hochfrequenzsender mit Cartesian-feedback Linearisierung mitbekannt. Ein digitaler Signalprozessor (DSP) erzeugt hier ein komplexes Eingangssignal für einen IQ-Modulator, der aus einem Inphase-Mischer, einem Quadraturphase-Mischer und einem Summierer sowie einem Phasenschieber besteht. Das komplexe Eingangssignal besteht aus einer Inphase-Komponente I und einer Quadraturphase-Komponente Q, wobei die Inphase-Komponente I dem Inphase-Mischer und die Quadraturphase-Komponente Q dem Quadraturphase-Mischer zugeführt wird. Dem Phasenschieber wird das Ausgangssignal eines lokalen Oszillators zugeführt, wobei der Phasenschieber dieses Oszillatorsignal dem Inphase-Mischer ohne Phasenverschiebung und dem Quadraturphase-Mischer unter einer Phasenverschiebung von 90° zuführt.

Dem Quadraturmodulator ist ein Leistungsverstärker nachgeschaltet, der das quadraturmodulierte Signal entsprechend der Sendeleistung der Sendeeinrichtung leistungsverstärkt einer Antenne zuführt. Im weiteren schaltet der digitale Signalprozessor die Versorgungsspannung des Leistungsverstärkers beim Übergang in den Empfangsbetrieb ab, bzw. kurz vor dem Übergang in den Sendebetrieb wieder zu.

In dem Signalpfad zwischen dem Leistungsverstärker und der Antenne befindet sich ein Auskoppler, der das Ausgangssignal des Leistungsverstärkers in eine Rückkopplungsschleife einkoppelt. Ein Eingang eines Quadraturdemodulators ist mit dem Auskoppler verbindbar. Der Ausgang des Quadraturdemodulators ist mit einem Differenzverstärker verbunden.

Durch diese, allgemein als Cartesian-feedback bezeichnete Rückkopplungs-Anordnung wird erreicht, daß Linearisierungsfehler des Leistungsverstärkers kompensiert werden.

Zur Kompensation der insbesondere durch den Quadraturmodulator, den Quadraturdemodulator und den Leistungsverstärker hervorgerufenen Phasenverschiebung, kommt in der besagten Druckschrift ein Phasenschieber zum Einsatz, welcher auf Zwischenfrequenz-Ebene oder einer Hochfrequenz-Ebene wirksam ist und die Phasenlage der jeweils zugeführten Trägerfrequenz verändert.

Nachteilig ist bei der DE 199 46 669 A1, daß die Veränderung der Phasenlage durch den Phasenschieber nur unzureichend genau reproduzierbar ist, der nutzbare Frequenzbereich meist nicht ausreicht, das Trägersignal durch ein Eigenrauschen des Phasenschiebers breitbandig gestört ist und der Platzbedarf relativ groß ist. Insbesondere die schlechte Reproduzierbarkeit führt zur Notwendigkeit eines individuellen Abgleichs der Schaltungsanordnung und dadurch zu einem hohen Prüfaufwand mit einem erheblichen Kostenaufwand.

Der Artikel MUHONEN K ET AL:" Amplifier linearization for the local multipoint distribution system application" PERSONAL, INDOOR AND MOBILE RADIO COMMUNICATIONS, 1998. THE NINTH IEEE INTERNATIONAL SYMPOSIUM ON BOSTON, MA, USA 8-11 SEPT. 1998, NEW YORK, NY, USA, IEEE, US, 8. September 1998, Seiten 687-692, ISBN: 0-7803-4872-9, beschreibt ebenfalls ein System zur Realisierung einer Cartesian-feedback Linearisierung mit einem digitalen Signalprozessor (DSP), wobei einem Ausgang des DSP das zu sendende Signal im Basisband zur Verfügung steht und an einem Eingang ein von der Antenne rückgekoppeltes Signal eingespeist werden kann. DSP-intern wird das Signal modifiziert in einem Vorwärtspfad dem Sendesignal überlagert, wobei zur Verbesserung der Linearisierung auf eine Predistortion-Korrektur zurückgegriffen wird. So ergeben sich auch bei dieser Verfahrensweise obengenannte Nachteile.

Es ist daher Aufgabe der Erfindung eine Sendereinrichtung anzugeben, die die zuvor genannten Nachteile vermeidet und eine Phasenkompensation mit geringem Aufwand und hoher reproduzierbarer Genauigkeit ermöglicht.

Die Aufgabe wird erfindungsgemäß durch eine rückkopplungslinearisierte Sendereinrichtung mit den kennzeichnenden Merkmalen des Anspruchs 1 in Verbindung mit den gattungsgemäßen Merkmalen gelöst.

Erfindungsgemäß wird die zur Linearisierung bzw. Entzerrung notwendige Phasendrehung nicht auf der Zwischenfrequenz- oder Hochfrequenzebene sondern auf der Basisband-Ebene durch eine besondere Korrektureinrichtung vollzogen. Die unerwünschte und insbesondere frequenzabhängige Phasenverschiebung, welche insbesondere durch den Modulator, den Demodulator und den Leistungsverstärker hervorgerufen sind, werden dadurch in einfacher Weise, genau reproduzierbar, ohne Frequenzbeschränkungen und mit besonders geringem Aufwand kompensiert. Die Erfindung eignet sich durch den geringen Platzbedarf in besonderer Weise zur Ausführung als integrierte oder teilweise integrierte Schaltung.

Vorteilhafte Weiterbildungen gehen aus den Unteransprüchen hervor.

In einer ersten Weiterbildung arbeitet die Korrekturschaltung gemäß der in Anspruch 2 wiedergegebenen Weise und ist gemäß Anspruch 2 aufgebaut. Dadurch ist es möglich, die Korrekturschaltung besonders einfach und damit insbesondere kostengünstig aufzubauen.

Durch die in Anspruch 3 wiedergegebenen Merkmale lassen sich das Inphasen-Korrekturausgangssignal und das Quadraturphasen-Korrekturausgangssignal in besonders einfacher Weise ermitteln.

Durch die in einer Tabelle abgelegten Werte für einen einer bestimmten Trägerfrequenz zugeordneten Phasenfehler lassen sich die Phasenfehlerwerte besonders schnell und einfach einer sich ändernden Trägerfrequenz anpassen, insbesondere wenn die Sendeeinrichtung im Frequenz-Sprung-Betrieb (Frequency Hopping Mode) betrieben wird, so wie dies bei Bündelfunk-Systemen oder Mobilfunk-Systemen üblich ist.

Vereinfachte Ausführungsbeispiele der Erfindung werden nachfolgend unter Bezugnahme auf die Zeichnungen näher beschrieben. Übereinstimmende Element sind dabei mit übereinstimmenden Bezugszeichen versehen. In der Zeichnung zeigen:

Fig. 1      ein Blockschaltbild eines ersten Ausführungsbeispiels einer erfindungsgemäßen Sendereinrichtung,

Fig. 2      ein Blockschaltbild eines zweiten Ausführungsbeispiels einer erfindungsgemäßen Sendereinrichtung und

Fig. 3      ein Blockschaltbild einer Ausführungsform einer Korrekturschaltung einer erfindungsgemäßen Sendereinrichtung.

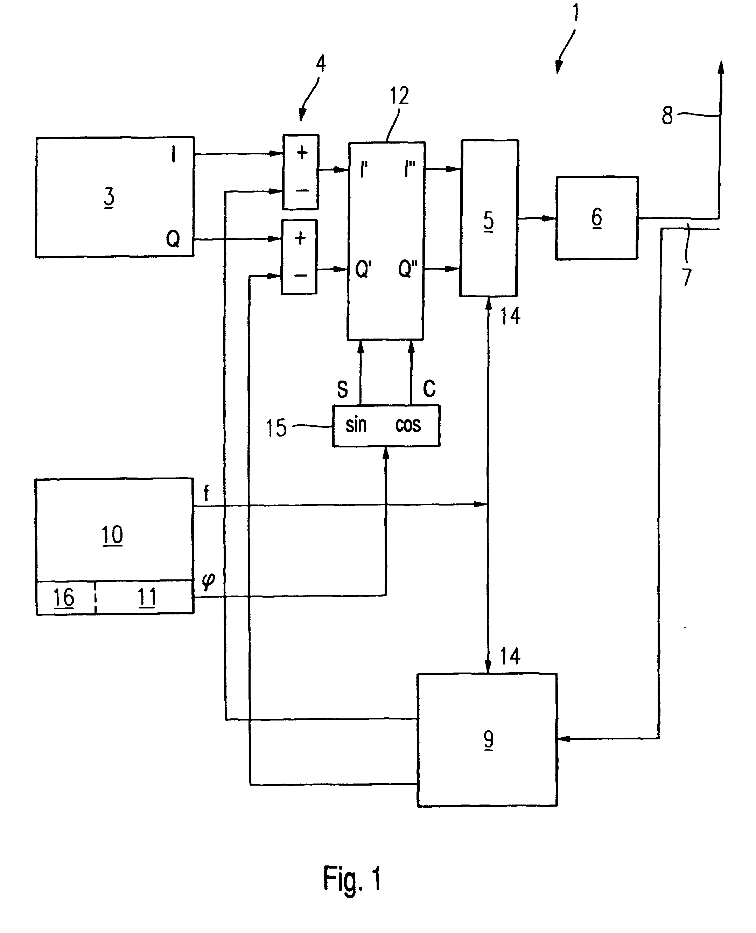

Fig. 1 zeigt ein Blockschaltbild eines ersten Ausführungsbeispiels einer erfindungsgemäßen Sendereinrichtung 1, wobei die Sendereinrichtung 1 bevorzugt in funktechnischen Anlagen Verwendung findet, aber auch in anderen elektronischen Schaltungen als Signalquelle bzw. als signalverarbeitendes Element im weitesten Sinne verwendet werden kann.

Die Sendereinrichtung 1 weist eine Basisbandaufbereitung 3, welche in diesem Ausführungsbeispiel als digitaler Signalprozessor ausgeführt ist, auf. Eine Ausgleichsschaltung 4 empfängt an ihren nichtinvertierenden Eingängen "+" von der Basisbandaufbereitung 3 ein Inphasen-Eingangssignal I und ein Quadraturphasen-Eingangssignal Q. Die Ausgleichsschaltung 4 gibt andererseits ein Inphasen-Korrektureingangssignal I' und ein Quadraturphasen-Korrektureingangssignal Q' an eine Korrekturschaltung 12 weiter. Die Korrekturschaltung 12 empfängt die Signale I' und Q' und verarbeitet diese unter Einbeziehung von einer ersten Stellgröße C und einer zweiten Stellgröße S zu einem Inphasen-Korrekturausgangssignal I'' und einem Quadraturphasen-Korrekturausgangssignal Q'', welche an den im Vorwärtspfad in diesem Ausführungsbeispiel nach der Korrekturschaltung 12 folgenden Quadratur-Modulator 5 weitergegeben werden. Ein im Quadratur-Modulator 5 erzeugtes Hochfrequenzsignal wird an eine Verstärkerstufe 6 abgegeben, dort verstärkt und an einen Hochfrequenz-Ausgang 8 geleitet. Das an den Hochfrequenz-Ausgang 8 geleitete Hochfrequenzsignal wird nach der Verstärkerstufe 6 durch einen Auskoppler 7 ausgekoppelt und so dem Rückkopplungspfad zugeführt. Das ausgekoppelte Hochfrequenzsignal wird zuerst einem Quadratur-Demodulator 9 zugeführt, welcher durch einen Trägerfrequenz-Oszillator 10 mit derselben Trägerfrequenz f wie der Quadratur-Modulator 5 versorgt ist, wo das Hochfrequenzsignal auf Basisband-Ebene zurückmoduliert, in seine zwei idealerweise zueinander orthogonalen Komponenten zerlegt bzw. getrennt wird und an die Ausgleichsschaltung 4 auf deren invertierende Eingänge "-" geleitet wird.

Die Basisband-Ebene erstreckt sich dabei im Vorwärtspfad von der Basisbandaufbereitung 3, über die Ausgleichsschaltung 4 und die Korrekturschaltung 12 bis vor den Quadratur-Modulator 5. Im Rückkopplungpfad, welcher sich vom Auskoppler 7 über den Quadratur-Demodulator 9 bis zur Ausgleichsschaltung 4 erstreckt, reicht die Basisband-Ebene von nach dem Quadratur-Demodulator 9 bis zur Ausgleichsschaltung 4.

Eine Steuereinrichtung 11, die mit dem Trägerfrequenz-Oszillator 10 in Kontakt steht, steuert im Ausführungsbeispiel die Korrekturschaltung 12 in Abhängigkeit der gerade jeweils verwendeten Trägerfrequenz 14, wobei in diesem Ausführungsbeispiel ein bei der jeweiligen Trägerfrequenz f zu erwartender Phasenfehler φ aus einer Look-up-Tabelle 16 von der Steuereinrichtung 11 empfangen und, beispielsweise in Form von Spannungssignalen bzw. Spannungsstufen, an ein Bestimmungsglied 15 weitergegeben wird. In diesem Ausführungsbeispiel ermittelt das Bestimmungsglied 15 anhand des jeweiligen Phasenfehlers φ die dazugehörige erste Stellgröße C und zweite Stellgröße S, wobei die erste Stellgröße C dem Sinus des Phasenfehlers φ und die zweite Stellgröße S dem Cosinus des Phasenfehlers φ gleichen bzw. diesen proportional sind.

Die in diesem Ausführungsbeispiel dargestellte Sendeeinrichtung 1 arbeitet wie eine Verstärkeranordnung, welche nach der bekannten Methode des Cartesian Feedback linearisiert ist. Die insbesondere in der Verstärkerstufe verursachte unerwünschte Phasenverschiebung wird erfindungsgemäß dabei vollständig auf der Basisband-Ebene durch die Korrekturschaltung 12 kompensiert.

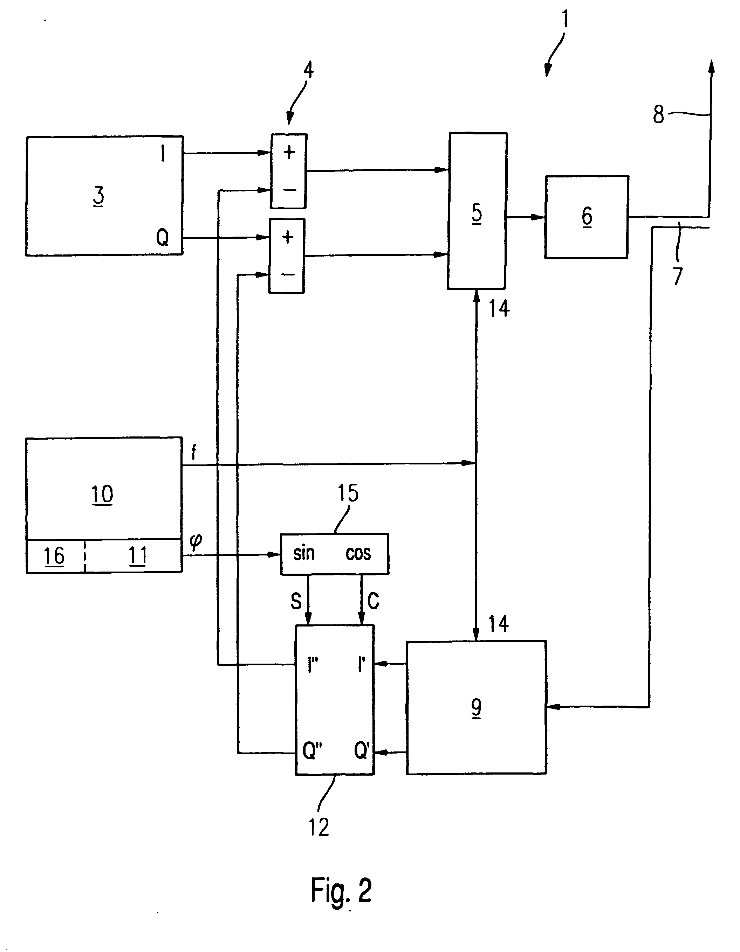

Fig. 2 zeigt ein Blockschaltbild eines zweiten Ausführungsbeispiels einer erfindungsgemäßen Sendereinrichtung 1, ähnlich dem ersten Ausführungsbeispiel aus Fig. 1, jedoch ist die Korrekturschaltung 12 zwischen dem Quadratur-Demodulator und der Ausgleichsschaltung 4 im Rückkopplungspfad angeordnet.

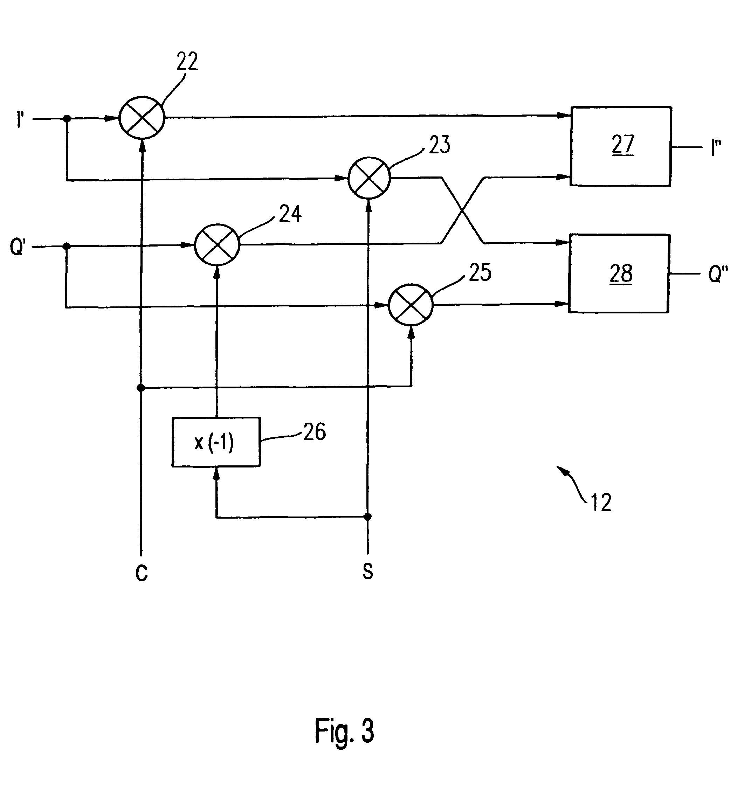

Fig. 3 zeigt ein Blockschaltbild einer möglichen Ausführungsform einer Korrekturschaltung 12 einer erfindungsgemäßen Sendereinrichtung 1 mit einem ersten Multiplizierer 22 und einem zweiten Multiplizierer 23, denen ein Inphasen-Korrektureingangssignal I' zugeführt ist, und einem dritten Multiplizierer 24 und einem vierten Multiplizierer 25, denen ein Quadraturphasen-Korrektureingangssignal Q' zugeführt ist. Ein erster Summierer 27, der einerseits mit dem ersten Multiplizierer 22 und dem dritten Multiplizierer 24 verbunden ist, gibt andererseits ein Inphasen-Korrekturausgangssignal I" aus. Ein zweiter Summierer 28, der einerseits mit dem zweiten Multiplizierer 23 und dem vierten Multiplizierer 25 verbunden ist, gibt andererseits ein Quadraturphasen-Korrekturausgangssignal Q" aus. Dem ersten Multiplizierer 22 und dem vierten Multiplizierer 25 wird außerdem noch die erste Stellgröße C zugeführt. Die zweite Stellgröße S wird dem zweiten Multiplizierer 23 direkt und dem dritten Multiplizierer 24 über einen Inverter 26 zugeführt.

Die Korrekturschaltung 12 teilt die beiden auf der Basisband-Ebene liegenden Eingangssignale I' und Q' nach Maßgabe der beiden Stellgrößen S, C so auf, daß die beiden Ausgangssignale I" und Q" die insbesondere durch die Verstärkerstufe und die Modulatoren verursachten Phasenverschiebung kompensieren. Die Korrekturgleichungen sind damit wie folgt:

$$I'' = I' \cdot C - Q' \cdot S \qquad (1)$$

$$Q'' = Q' \cdot C + I' \cdot S \qquad (2)$$

mit

$$C = \cos(\varphi) \qquad (3)$$

$$S = \sin(\varphi) \qquad (4)$$

Die Erfindung ist nicht auf die dargestellten Ausführungsbeispiele beschränkt. Insbesondere können alle Merkmale aller Ausführungsbeispiele auch miteinander kombiniert werden.

**Patentansprüche**

1. Sendereinrichtung (1) mit einer Basisbandaufbereitung (3) an deren Ausgang ein komplexes Basisband-Signal auf Basisband-Ebene mit zwei Komponenten auftritt, einem Vorwärtspfad, der einen Quadratur-Modulator (5) und zumindest eine Verstärkerstufe (6) aufweist, einem Rückkopplungspfad, der einen Quadratur-Demodulator (9) aufweist, und einer zwischen der Basisbandaufbereitung (3) und dem Quadratur-Modulator (5) angeordneten Ausgleichsschaltung (4), wobei ein Hochfrequenzsignal nach der Verstärkerstufe (6) ausgekoppelt und dem Quadratur-Demodulator (9) zugeführt ist und wobei die Basisband-Ebene sich im Vorwärtspfad von der Basisbandaufbereitung(3) bis zum Quadratur-Modulator (5) und im Rückkopplungspfad vom Quadratur-Demodulator (9) bis zur Ausgleichsschaltung (4) erstreckt,
**dadurch gekennzeichnet,**
**daß** eine für die Entzerrung notwendige Phasenkorrektur auf der Basisband-Ebene durch zumindest eine Korrekturschaltung (12) durch multiplikative Verknüpfung des komplexen Basisband-Signals mit zu mindest einer Sellgröbe bewirkt wird.

2. Sendereinrichtung nach Anspruch 1,
**dadurch gekennzeichnet,**
**daß** die Korrekturschaltung (12) einen ersten Multiplizierer (22) und einen zweiten Multiplizierer (23) aufweist, denen ein Inphasen-Korrektureingangssignal I' zugeführt ist, einen dritten (24) und vierten (25) Multiplizierer aufweist, denen ein Quadraturphasen-Korrektureingangsignal Q' zugeführt ist, einen ersten Summierer (27) aufweist, der einerseits mit dem ersten Multiplizierer (22) und dem dritten Multiplizierer (24) verbunden ist und der andererseits ein Inphasen-Korrekturausgangssignal I" ausgibt, einen zweiten Summierer (28) aufweist, der einerseits mit dem zweiten Multiplizierer (23) und dem vierten Multiplizierer (25) verbunden ist und der andererseits ein Quadraturphasen-Korrekturausgangssignal Q" ausgibt, wobei dem ersten Multiplizierer (22) und dem vierten Multiplizierer (25) eine erste Stellgröße C zugeführt ist und eine zweite Stellgröße S dem zweiten Multiplizierer (23) direkt und dem dritten Multiplizierer (24) über einen Inverter (26) zugeführt ist.

3. Sendereinrichtung nach Anspruch 2,
**dadurch gekennzeichnet,**
**daß** über einen Phasenfehler φ die erste Stellgröße C und die zweite Stellgröße S nach folgenden Gleichungen berechnet sind:

$$C = \cos(\varphi)$$

$$S = \sin(\varphi)$$

und das Inphasen-Korrekturausgangssignal (I") und das Quadraturphasen-Korrekturausgangssignal (Q") nach folgenden Gleichungen berechnet sind:

$$I'' = I' \cdot C - Q' \cdot S$$

$$Q'' = Q' \cdot C + I' \cdot S$$

**4.** Sendereinrichtung nach Anspruch 3,
**dadurch gekennzeichnet,**
**daß** die Sendereinrichtung zwischen mehreren Trägerfrequenzen umschaltbar ist und jeder Trägerfrequenz f in einer Look-up-Tabelle (16) ein bestimmter Phasenfehler φ zugeordnet ist.

**5.** Sendereinrichtung nach einem der Ansprüche 2 bis 4,
**dadurch gekennzeichnet,**
**daß** eine Steuereinrichtung (11) die Korrekturschaltung (12) in Abhängigkeit der jeweils verwendeten Trägerfrequenz f steuert.

**6.** Sendereinrichtung nach Anspruch 5,
**dadurch gekennzeichnet,**
**daß** die Steuereinrichtung (11) die Korrekturschaltung (12) über ein Bestimmungsglied (15) steuert, welches von der Steuereinrichtung (11) den Phasenfehler φ empfängt.

**7.** Sendereinrichtung nach Anspruch 6,
**dadurch gekennzeichnet,**
**daß** das Bestimmungsglied (15) über den von der Steuereinrichtung (11) übermittelten Phasenfehler φ die zwei Stellgrößen C, S ermittelt bzw. berechnet, welche an die Korrekturschaltung (12) weitergegeben werden.

**8.** Sendereinrichtung nach einem der vorangegangenen Ansprüche,
**dadurch gekennzeichnet,**
**daß** die Korrekturschaltung (12) im Vorwärtspfad vor dem Quadratur-Modulator (5) angeordnet ist.

**9.** Sendereinrichtung nach einem der vorangegangenen Ansprüche,
**gekennzeichnet durch**
daß die Korrekturschaltung (12) im Rückkopplungspfad nach dem Quadratur-Demodulator (9) angeordnet ist.

**10.** Sendereinrichtung nach einem der vorangegangenen Ansprüche,
**dadurch gekennzeichnet,**
**daß** sowohl der Quadratur-Modulator (5) als auch der Quadratur-Demodulator (9) mit derselben Trägerfrequenz (14) versorgt sind.

## Claims

**1.** Transmitter device (1) with a baseband conditioning unit (3), at the output of which, a complex baseband signal occurs at the baseband level with two components, a forward path, which provides a quadrature modulator (5) and at least one amplifier level (6), a feedback path, which provides a quadrature demodulator (9), and an equalising circuit (4) arranged between the baseband conditioning unit (3) and the quadrature modulator (5), wherein a high-frequency signal is decoupled after the amplifier level (6) and supplied to the quadrature demodulator (9), and wherein the baseband level extends in the forward path from the baseband conditioning unit (3) to the quadrature modulator (5), and in the feedback path from the quadrature demodulator (9) to the equalising circuit (4),
**characterised in that**
a phase correction on the baseband level required for the equalisation is achieved by at least one correction circuit (12) through multiplicative linking of the complex baseband signal with at least one adjustment parameter.

**2.** Transmitter device according to claim 1,
**characterised in that**
the correction circuit (12) comprises a first multiplier (22) and a second multiplier (23), to which an in-phase correction input signal I' is supplied; a third (24) and a fourth (25) multiplier, to which a quadrature phase correction input signal Q' is supplied; a first summer (27), which is connected at one end to the first multiplier (22) and the third multiplier (24), and which, at the other end, emits an in-phase correction output signal I''; a second summer (28), which is connected at one end to the second multiplier (23) and the fourth multiplier (25), and which, at the other end, emits a quadrature phase correction output signal Q'', wherein a first adjustment parameter C is supplied to the first multiplier (22) and the fourth multiplier (25), and a second adjustment parameter S is supplied directly to the second multiplier (23) and via an inverter (26) to the third multiplier (24).

**3.** Transmitter device according to claim 2,
**characterised in that**
the first adjustment parameter C and the second adjustment parameter S are calculated via a phase error φ; according to the following equations:

$$C = \cos(\varphi;)$$

$$S = \sin(\varphi;)$$

and the in-phase correction output signal (I'') and the quadrature-phase correction output signal (Q'') are calculated according to the following equations:

$$I''=I'.C-Q'.S$$

$$Q''=Q'.C+I'.S$$

**4.** Transmitter device according to claim 3, **characterised in that** the transmitter device can be switched between several carrier frequencies and that a given phase error φ; is assigned to each carrier frequency f in a look-up table (16).

**5.** Transmitter device according to any one of claims 2 to 4, **characterised in that** a control device (11) controls the correction circuit (12) dependent upon the relevant carrier frequency f used.

**6.** Transmitter device according to claim 5, **characterised in that** the control device (11) controls the correction circuits (12) via a test element (15), which receives the phase error φ; from the control device (11).

**7.** Transmitter device according to claim 6, **characterised in that**, via the phase error φ; transferred from the control device, the test element (15) determines and/or calculates the two adjustment parameters C, S, which are passed on to the correction circuit (12).

**8.** Transmitter device according to any one of the preceding claims, **characterised in that** the correction circuit (12) is arranged in the forward path before the quadrature modulator (5).

**9.** Transmitter device according to any one of the preceding claims, **characterised in that** the correction circuit (12) is arranged in the feedback path after the quadrature demodulator (9).

**10.** Transmitter device according to any one of the preceding claims, **characterised in that** both the quadrature modulator (5) and also the quadrature demodulator (9) are supplied with the same carrier frequency (14).

**Revendications**

**1.** Circuit émetteur (1) avec une préparation de bande de base (3) à la sortie de laquelle se produit un signal de bande de base complexe sur un plan de bande de base avec deux composantes, un chemin avant qui présente un modulateur de quadrature (5) et au moins un étage amplificateur (6), un chemin à rétroaction qui présente un démodulateur de quadrature (9) et un circuit de compensation (4) disposé entre la préparation de bande de base (3) et le modulateur de quadrature (5), où un signal haute fréquence est désaccouplé en aval de l'étage amplificateur (6) et est transmis au démodulateur de quadrature (9), et où le plan de bande de base s'étend dans le chemin avant depuis la préparation de bande de base (3) jusqu'au modulateur de quadrature (5) et dans le chemin à rétroaction du démodulateur de quadrature (9) jusqu'au circuit de compensation (4), **caractérisé en ce qu'**est provoquée une correction de phase nécessaire pour la correction de distorsion sur le plan de bande de base par au moins un circuit de correction (12) par une connexion multiplicatrice du signal de bande de base complexe avec au moins une grandeur de réglage.

**2.** Circuit émetteur selon la revendication 1, **caractérisé en ce que** le circuit de correction (12) présente un premier multiplicateur (22) et un deuxième multiplicateur (23), auxquels est amené un signal d'entrée de correction en phase I', présente un troisième (24) et un quatrième (25) multiplicateur auxquels est amené un signal d'entrée de correction de phase de quadrature Q', présente un premier additionneur (27) qui est relié d'une part au premier multiplicateur (22) et au troisième multiplicateur (24) et qui émet, d'autre part, un signal de sortie de correction en phase I'', présente un deuxième additionneur (28) qui est relié d'une part au deuxième multiplicateur (23) et au quatrième multiplicateur (25) et qui émet d'autre part un signal de sortie de correction de phase de quadrature Q'', où est amenée au premier multiplicateur (22) et au quatrième multiplicateur (25) une première grandeur de réglage C, et une deuxième grandeur de réglage S est amenée au deuxième multiplicateur (23) directement et au troisième multiplicateur (24) par un inverseur (26).

**3.** Circuit émetteur selon la revendication 2, **caractérisé en ce que** la première grandeur de réglage C et la deuxième grandeur de réglage S sont calculées, par une erreur de phase φ selon les équations suivantes:

$$C = \cos(\varphi)$$

$$S = \sin(\varphi)$$

et le signal de sortie de correction en phase (I'') et le signal de sortie de correction de phase de quadrature (Q") sont calculés selon les équations suivantes:

$$I'' = I' . C - Q' . S$$

$$Q'' = Q' . C + I' . S$$

4. Circuit émetteur selon la revendication 3, **caractérisé en ce que** le circuit émetteur peut être commuté entre plusieurs fréquences porteuses et qu'il est associé à chaque fréquence porteuse f dans un tableau de consultation (16) une erreur de phase déterminée φ.

5. Circuit émetteur selon l'une des revendications 2 à 4, **caractérisé en ce qu'**une installation de commande (11) commande le circuit de correction (12) en fonction de la fréquence porteuse f respectivement utilisée.

6. Circuit émetteur selon la revendication 5, **caractérisé en ce que** le dispositif de commande (11) commande le circuit de correction (12) par un élément de détermination (15) qui reçoit de l'installation de commande (11) l'erreur de phase φ.

7. Circuit émetteur selon la revendication 6, **caractérisé en ce que** l'élément de détermination (15) détermine respectivement calcule par l'erreur de phase φ transmise par l'installation de commande (11) les deux grandeurs de réglage C, S qui sont transmises au circuit de correction (12).

8. Circuit émetteur selon l'une des revendications précédentes, **caractérisé en ce que** le circuit de correction (12) est disposé dans le chemin avant en amont du modulateur de quadrature (5).

9. Circuit émetteur selon l'une des revendications précédentes, **caractérisé en ce que** le circuit de correction (12) est disposé dans le chemin à rétroaction en aval du démodulateur de quadrature (9).

10. Circuit émetteur selon l'une des revendications précédentes, **caractérisé en ce qu'**à la fois le modulateur de quadrature (5) et le démodulateur de quadrature (9) sont alimentés avec la même fréquence porteuse (14).

Fig. 1

Fig. 2

Fig. 3